Europäisches Patentamt

(19) European Patent Office

Office européen des brevets

(11) Publication number : **0 225 364 B1**

## (12) EUROPEAN PATENT SPECIFICATION

(45) Date of publication of patent specification :
06.11.91 Bulletin 91/45

(51) Int. Cl.⁵ : **H02J 7/14, G01R 31/36**

(21) Application number : **86903478.5**

(22) Date of filing : **27.05.86**

(86) International application number :
**PCT/GB86/00290**

(87) International publication number :
**WO 86/07502 18.12.86 Gazette 86/27**

(54) **MONITORING STATE OF BATTERY CHARGE.**

(30) Priority : **12.06.85 DE 3520985**

(43) Date of publication of application :
**16.06.87 Bulletin 87/25**

(45) Publication of the grant of the patent :
**06.11.91 Bulletin 91/45**

(84) Designated Contracting States :
**BE DE FR GB IT NL SE**

(56) References cited :
**EP-A-00 797 88**
**DE-A-31 163 71**
**US-A- 3 617 850**
**US-A-42 348 40**
**US-A-43 331 49**
**US-A-43 777 87**
**See also references of WO8607502**

(73) Proprietor : **FORD MOTOR COMPANY LIMITED**
**Eagle Way**
**Brentwood Essex CM13 3BW (GB)**
**BE GB IT NL SE**
Proprietor : **FORD-WERKE AKTIENGESELLSCHAFT**
**Ottoplatz 2 Postfach 21 03 69**
**W-5000 Köln 21 (DE)**
**DE**
Proprietor : **FORD FRANCE SOCIETE ANONYME**
**344 Avenue Napoléon Bonaparte B.P. 307**
**F-92506 Rueil Malmaison Cedex (FR)**
**FR**

(72) Inventor : **STEFFENS, Willi**
**Jagerstr. 17-19**
**W-5100 Aachen (DE)**

(74) Representative : **Messulam, Alec Moses et al**
**A. Messulam & Co. 24 Broadway**
**Leigh on Sea Essex SS9 1BN (GB)**

## Description

The invention relates to a method and apparatus for monitoring the state of charge of a storage battery. The invention is particularly applicable to monitoring the charge in a motor vehicle and is described below by reference to such an embodiment.

Lead acid accumulators are often used as the starter batteries of motor vehicles powered by internal combustion engines. The starter battery during engine starting supplies current to a starter motor temporarily coupled to the engine. After starting the internal combustion engine, the storage battery is recharged by a generator or alternator driven by the internal combustion engine.

When the vehicle is stationary, the starter battery may also power a parking light as well as loads of lower power consumption such as an electric clock in the vehicle and other monitoring devices.

Studies have shown that in the great majority of cases, the alternator can meet the current requirements of the various loads during normal usage of the vehicle and can also recharge the battery to compensate for the loss of charge during starting provided that the vehicle is not used exclusively for short journeys, with very frequent stopping and starting, or for long periods with all the electrical loads switched on. It is also necessary for the battery, in the event of a sudden failure of the generator, to be able to continue for a limited period to provide power for the ignition system of the internal combustion engine.

In addition to the standard electrical features such as the lights and the windscreen wipers, the battery must when necessary also supply electrical power to electrical loads such as for example an antilocking system for the vehicle brakes, automatic vehicle speed control (cruise control) etc., since their sudden failure would pose a considerable to risk to safety, and such loads are becoming increasingly common in modern vehicles.

It is therefore becoming ever more necessary to monitor the state of charge of the battery continuously and to warn the driver in good time when the state of charge of the battery threatens to drop to a critical level.

Hitherto motor vehicles, in particular passenger cars, have not had any device at all for indicating the state of charge of the starter battery. At best, they have made do with a voltmeter which provides little information on the actual state of charge. It is of course possible to monitor the state of charge of the battery by checking the density of the acid after the battery has been unused for a period of some hours, but this is inaccurate under dynamic conditions and awkward to do on a regular basis and therefore is of little practical value.

US-A-4 333 149 describes an electric vehicle in which the state of charge of the battery is determined by measuring and integrating the discharge or charge current over time and comparing the result with the battery capacity in accordance with the features of the first parts of claims 1 and 4.

During each starting procedure, the starter battery is subjected to a momentary loading with a high discharge current, in which the diffusion in the battery cells does not keep pace with the acid consumption. The greater the strength of the current, the sooner the storage battery is run down and the smaller its actually usable capacity becomes. If on the other hand the storage battery is discharged at intervals, giving the acid in the cells time in which it can balance itself out again, recovery takes place and the capacity is greater. It is also possible after the battery has been run down by discharging it, to discharge it further with a reduced strength of the current as the reduced current necessitates a reduced diffusion.

The present invention seeks to provide a method and apparatus for monitoring the state of charge of a storage battery, in particular the starter battery of a motor vehicle, which can continuously monitor the state of charge under widely varying operating conditions in a simple manner, can be implemented inexpensively, and can provide a timely indication when the state of charge of the battery is low so that a warning may be given to the driver or remedial action may be taken automatically.

According to a first aspect of the present invention, there is provided a method of monitoring the state of charge of a storage battery, which comprises the steps of storing reference data representative of the state of charge, measuring the battery voltage, the battery temperature, and the current flowing through the battery to provide an indication of the state of charge, integrating, when a charging means and/or significant loads are switched on, the measured current to provide an indication of the charge loss or gain following the measurement of the battery voltage, and continuously estimating the available remaining charge from the stored reference data and the result of the integration; characterised in that the estimating of the available remaining charge comprises the further steps of measuring the voltage and its variation with time in a substantially open circuit, correlating, if this substantially open state persists for a prolonged period of time, the measured variation of the rest voltage with previously stored corresponding variations measured for batteries having a known state of charge, predicting from this variation the relaxation voltage, as herein defined, of the battery to provide the indication of the state of charge by comparing the relaxation voltage with the stored reference data, and correcting the predicted relaxation voltage by each direct measurement of the relaxation voltage.

The invention also provides an apparatus for performing the above method, comprising measuring means for the continuous measurement of the battery current and the battery voltage; an integrator connected to the current-measuring means for determining the charge drawn from and delivered to the battery, means for calculating a notional battery capacity from the measured voltage and the charge drawn from and delivered to the battery, means for comparing the drawn and delivered charge, which the integrator continuously determines when the battery current flows again, with the calculated notional battery capacity, and thus for continuously determining the state of charge, and a device for continuously measuring the battery temperature for forming a correction value for the notional battery capacity from the comparison of the measured temperature with a predetermined nominal temperature, characterised in that a device is connected to the voltage-measuring means and is controllable by the current-measuring means for measuring the rest voltage and the relaxation voltage in a substantially open circuit, and that it comprises means for correlating, if this substantially open state persists for a prolonged period of time, the temperature compensated measured variation of the rest voltage with the previously stored corresponding variations measured for batteries having a known state of charge and for predicting from this variation the relaxation voltage, and means for correcting the predicted relaxation voltage by each direct measurement of the relaxation voltage.

When a battery is allowed to stand with minimal current being taken from it after a period of use, the output voltage of the battery measured in a substantially open circuit will drift towards a steady state value after some time and this is herein referred to as the relaxation voltage.

The relaxation voltage is known from US-A-4 234 840 to be a reliable indication of the remaining charge and within acceptable limits does not vary with battery age. If the battery was being discharged prior to relaxation, the output voltage rises steadily at first and later approaches its steady state value asymptotically. Conversely, if the battery was being charged prior to relaxation, then the voltage will start higher than the relaxation voltage and will drop towards the steady state value, this time with a longer time constant. However, if no current at all is taken from the battery, then the steady state may not be reached for several five hours after discharging and even longer after charging.

In the present invention, a reliable prediction of the relaxation voltage is achieved in a shorter time by monitoring the rate at which the rest voltage changes and comparing this rate of change with rates of change measured for batteries having a known state of charge.

The relaxation voltage may thus be measured or estimated regularly to provide a reference value with which the charge taken from the battery can be compared. The integration of current alone is unreliable because of the cumulative errors which occur for example on account of the fact that the discharging effect is dependent upon the magnitude of the current. However, if the stored reference is updated at regular intervals then the subtraction of the calculated charge drawn from the battery from the previously estimated available charge provides a more accurate continuous indication of the state of charge and any cumulative errors in the integration are automatically corrected by each direct measurement of the relaxation voltage.

When used in a motor vehicle the method of the invention ensures a repeated correction of the calculation of the capacity each time the vehicle engine is switched off for a time and thus provides, virtually independently of the level of the discharge flow, a reliable indication of the actual state of charge, which may readily be utilised to produce an alarm or control signal when a predetermined minimum state of charge is detected.

Because the relaxation voltage is temperature dependent, the temperature of the starter battery needs to be measured continuously and is included in the detection of the state of charge as a correction value for the notional battery capacity. In this way the range of error is additionally limited while monitoring the state of charge and the effect of different ambient temperatures is minimised.

According to a further feature of the invention, to compensate for the dependence of the battery capacity upon the magnitude of the drawn current, a current dependent critical voltage may be derived from the voltage of the fully charged battery and the measured magnitude of the discharge current and the critical voltage may be compared with the constantly measured battery voltage to provide a warning or control signal.

The current measurements are carried out preferably at regular intervals during operation, in a predetermined timed sequence.

The computed remaining charge may be used not only to provide a warning indication but may be used to determine the recharge cycle and the charging rate when the engine is next turned on.

Because the method of the invention requires storage of data, comparison and integration over long periods of operation it lends itself well to implementation using digital techniques and is preferably carried out under micro-processor control. The micro-processor may be dedicated to this function or use may be made of a micro-processor serving other functions such as engine management or brake control.

The invention further provides apparatus as set forth in the claims for implementation of the method described above.

The invention will now be described further, by way of example, with reference to the accompanying drawings, in which:

Figure 1 is a block circuit diagram of an apparatus for performing the method according to the invention, and

Figure 2 is a diagram for illustrating the course of the off-load voltage of a lead storage battery as a function of the amount of current drawn from the battery.

Initial values for measuring and monitoring the state of charge of a starter battery (not shown in the drawing) are the battery voltage $U_{BAT}$; the battery current $I_{BAT}$ (which is assumed to be positive during discharging and negative during charging) and; the battery temperature $\theta$ (which in practice is substantially the same as the ambient temperature of the battery installation).

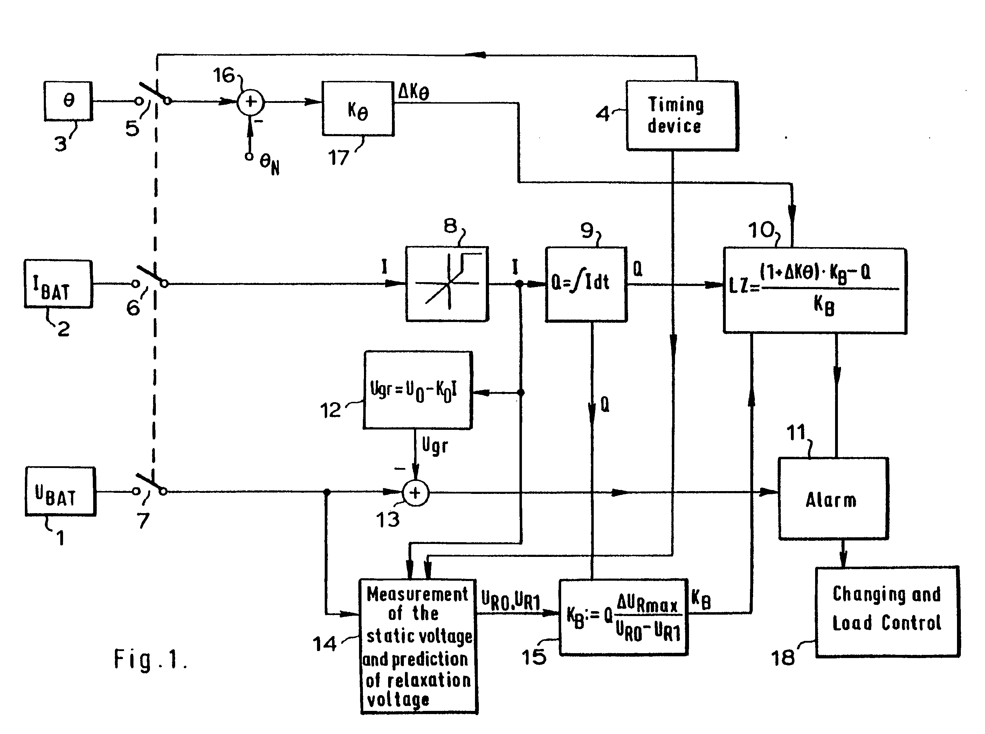

In Figure 1, the above-mentioned values $U_{BAT}$ and $I_{BAT}$ are recorded by measuring devices which are allocated the reference numerals 1 for the battery voltage, 2 for the battery current and 3 for the battery temperature and are converted into analogue or digital electrical signals which are passed on by a timing device 4 at, for example, one second intervals by way of switching devices 5, 6 and 7 respectively to the individual elements of an electronic apparatus for monitoring the state of charge of the battery.

The current signal I corresponding to the battery current $I_{BAT}$ is first pre-amplified in an amplifier 8 and is then integrated in an integrator 9 with respect to time in accordance with the equation

$$Q = \int I \, dt \quad (Eq.1).$$

The charge thereby obtained is supplied to a calculator unit 10 which calculates the state of charge, expressed as a percentage LZ of the full charge, in accordance with the equation

$$LZ = \frac{(1 + \Delta K_\theta)K_B - Q}{K_B} \times 100 \, [\%] \quad (Eq.2)$$

in which $K_B$ is the battery capacity and Q, depending upon the polarity sign, is the total charge drawn or resupplied, both measured in ampere hours, and $\Delta K_\theta$ is a temperature-dependent factor which is explained below.

If the state of charge drops to a critical value, a signal is supplied by the calculator unit 10 to an alarm 11 which warns the driver of this condition in a suitable manner, for example by means of a warning light and/or an audible signal. Alternatively, the output of the calculator unit 10 may automatically adapt the vehicle electronic loads and/or the recharge cycle and charging rate.

In one possible strategy, the voltage regulation may be first adapted to increase the recharging rate to compensate for excessive loading and if the charge in the battery continues to drop then load circuits may be sequentially disabled, in accordance with a set order of priority in order to ensure that adequate charge should remain for the circuits essential to the safe continued operation of the vehicle.

The control of the voltage regulation need not only be carried out in response to an unduly low remaining charge but may be used to reduce the load placed by the generator on the engine by disengaging the drive to the generator or driving the generator under no load conditions when the remaining charge exceeds a preset level. This can increase operating efficiency by removing the drag on the engine at times when the current requirements of the vehicle can be met from the stored battery charge alone.

The voltage signal U generated by the battery voltage $U_{BAT}$ is employed in two ways in monitoring the state of the battery. In the first place it is used to trigger a signal in the alarm 11 when the remaining charge drops below a current-dependent critical voltage $U_{gr}$. This critical value $U_{gr}$ is calculated in a critical voltage calculator 12 from a given initial voltage $U_o$ and the current signal I and a constant $K_o$ according to the equation :

$$U_{gr} = U_o - K_o.I \quad (Eq.3)$$

and is then substracted from the signal voltage U in a subtraction unit 13. The difference is passed on to the alarm 11 and triggers the latter on dropping to a predetermined minimum value irrespective of the state of charge detected in the calculator unit 10.

The voltage signal U is further supplied to a voltage recording unit 14 which is connected to a capacity calculating unit 15. The voltage recording unit 14 starts by registering the fact that either no current or a current not exceeding a low threshold value is flowing through the battery. If this state persists for a prolonged period of time, say a minimum of one hour, then the voltage and its rate of change are measured at this moment and are used to make a prediction of the relaxation voltage $U_{R1}$, this being the steady value of the voltage if enough time were allowed for relaxation. The predicted relaxation voltage is then passed to capacity calculating unit 15 to enable a theoretical battery capacity to be evaluated and this is passed on to the calculating unit 10 as a factor $K_B$ for computation of the charge state.

The time required for the voltage to reach a steady state can be considerably reduced by drawing a minimal current from the battery rather than no current at all and it is preferred to draw such a minimal current in order to increase the ease of measurement and prediction of the relaxation voltage. This minimal current is usually determined by the vehicle electronic accessories such as clocks, radios and trip computers. The prediction of the relaxation voltage need not be based on a single reading and it may instead be possible to plot the variation of the rest voltage with time and to correlate the resulting measurement graph with corresponding calibration graphs prepared for batteries with a known remaining charge.

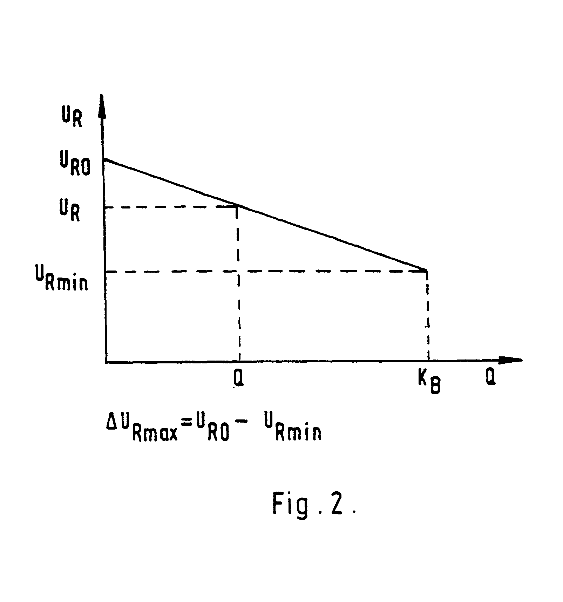

Computation of the theoretical battery capacity in the capacity-calculating unit 15 from the relaxation voltage predicted in the unit 14 is based on the known fact that between the acid density of the battery after relaxation, which is considered to be a measure of the state of charge of the battery, and the relaxation voltage there is a relationship which can be used to determine the actual state of charge of the battery. This correlation is shown in the graph of Figure 2.

Starting with the relaxation voltage $U_{R0}$ of the fully charged battery there is a substantially linear correlation between the charge Q drawn and the relaxation voltage $U_R$ up to the maximum charge $Q_{max}$ which can be drawn and which is equal to the capacity $K_B$ of the battery. Tests on a number of different lead accumulators have shown that the minimum rest voltage $U_{Rmin}$, corresponding to maximum discharge of the battery $(Q_{max} = K_B)$ is approximately equal to $0.9 . U_{RO}$.

With the help of the following equation, derived from the linear correlation represented in Figure 2,

$$U_{R1} = U_{RO} - Q_1 . \frac{U_{RO} - U_{Rmin}}{K_B} \quad (Eq.4)$$

and the relationship

$$U_{Ro} - U_{Rmin} = \Delta U_{Rmax} \quad (Eq.5)$$

the theoretical battery capacity, after appropriate conversion and incorporation of the charge Q passed from the integrator 9 to the capacity calculating unit 15, is calculated from the following equation :

$$K_B = Q . \frac{\Delta U_{Rmax}}{U_{RO} - U_{R1}}, \quad (Eq.6)$$

in which $U_{RO}$ is the relaxation voltage measured in the fully charged state of the battery by means of the relaxation voltage measuring device 14 and stored in the capacity-calculating unit 15.

On closer examination of equation 6, one can see that it is only possible to re-compute the theoretical battery capacity $K_B$ when $Q > 0$ and $U_{R1} < U_{R0}$.

Recording the course of the battery voltage and the battery current is not sufficient, however, for determining the charge state under greatly varying battery temperatures, since the battery temperature $\theta$ brings a considerable influence to bear on the charge state of the battery. It is therefore necessary, as mentioned in connection with Equation 1, to take into consideration a temperature factor $K_\theta$ when calculating the state of charge in the calculator unit 10, which is passed on by the temperature measurement device 3.

It is known that the capacity of a lead acid accumulator varies by approximately 1% per degree Celcius within the temperature range of 0°C to 40°C. Starting with a nominal temperature $\theta N$, which in vehicle batteries is set at 30°C, the battery capacity increases with higher temperatures and drops accordingly at temperatures lower than 30°C.

The temperature signal produced by the temperature measurement transducer 3 is therefore, after a signal corresponding to the nominal temperature $\theta_N$ has been subtracted in a substraction unit 16, supplied to a correction factor calculator unit 17, which calculates the correction factor $\Delta K_\theta$ already mentioned according to the equation

$$\Delta K_\theta = K_\theta . (\theta - \theta_N) \quad (Eq.7)$$

where $K_\theta$ may be taken as .01/°C, and passes it on to the calculator unit 10.

The apparatus schematically illustrated by a block circuit diagram in Figure 1 for evaluating the battery voltage, the battery current and the battery temperature and for determining and monitoring the state of charge of the battery can readily be translated into an electronic circuit by the person skilled in the art, where the measurement devices are appropriately combined with analog/digital converters since the analogous signal processing can be carried out digitally using a micro-processor. If an 8-bit conversion is employed, the resulting low resolution can necessitate omission of the start-up current from the current calculation. In order to take account of the start-up operation, a mean start-up current can be assumed and a time measurement alone can be relied upon to indicate the total loss of battery charge during starting.

## Claims

1. A method of monitoring the state of charge of a storage battery, which comprises the steps of:

   a) storing reference data representative of the state of charge,

   b) measuring the battery voltage $(U_{BAT})$, the battery temperature $(\theta)$, and the current $(I_{BAT})$ flowing through the battery to provide an indication of the state of charge,

   c) integrating, when a charging means and/or significant loads are switched on, the measured current $(I_{BAT})$ to provide an indication of the charge loss or gain (Q) following the measurement of the battery voltage $(U_{BAT})$, and

   d) continuously estimating the available remaining charge from the stored reference data and the result of the integration;

   characterised in that the estimating of the available remaining charge comprises the further steps of:

   e) measuring the voltage $(U_{BAT})$ and its variation with time in a substantially open circuit,

   f) correlating, if this substantially open state persists for a prolonged period of time, the measured variation of the rest voltage with previously stored corresponding variations measured for batteries having a known state of charge,

   g) predicting from this variation the relaxation voltage $(U_{R1})$, as herein defined, of the battery to provide the indication of the state of charge by comparing the relaxation voltage with the stored reference data, and correcting the predicted relaxation voltage by each direct measurement of the relaxation voltage ($U_{R1}$).

2. A method as claimed in claim 1, wherein a current dependent critical voltage is derived from the voltage of the fully charged battery and the measured magnitude of the discharge current and the critical voltage is compared with the constantly measured battery voltage to provide a warning indication.

3. A method as claimed in claim 1 or 2, wherein the computed state of charge of the battery is used to determine the recharge cycle and the charging rate when the engine is next turned on.

4. An apparatus for performing the method according to any preceding claim, comprising measuring means (1, 2) for the continuous measurement of the battery current ($I_{BAT}$) and the battery voltage ($U_{BAT}$); an integrator (9) connected to the current-measuring means (2) for determining the charge (Q) drawn from and delivered to the battery, means (15) for calculating a notional battery capacity ($K_B$) from the measured voltage and the charge (Q) drawn from and delivered to the battery, means (10) for comparing the drawn and delivered charge (Q), which the integrator (9) continuously determines when the battery current flows again, with the calculated notional battery capacity ($K_B$), and thus for continuously determining the state of charge (LZ), and a device (3) for continuously measuring the battery temperature (θ) for forming a correction value (ΔKθ) for the notional battery capacity from the comparison of the measured temperature (θ) with a predetermined nominal temperature ($θ_N$), characterised in that a device (14) is connected to the voltage-measuring means (1) and is controllable by the current-measuring means (2) for measuring the rest voltage and the relaxation voltage ($U_{R1}$) in a substantially open circuit, and that it comprises means for correlating, if this substantially open state persists for a prolonged period of time, the temperature compensated measured variation of the rest voltage with the previously stored corresponding variations measured for batteries having a known state of charge and for predicting from this variation the relaxation voltage, and means for correcting the predicted relaxation voltage by each direct measurement of the relaxation voltage ($U_{R1}$).

5. An apparatus according to Claim 4, comprising an alarm (11) connected to the means (10) for comparing the charge withdrawal (Q) with the notional battery capacity ($K_B$) and arranged to provide a warning or control signal when the state of the battery charge drops below a predetermined level.

6. An apparatus according to Claims 4 or 5, further comprising means (12) for continuously determining a maximum value ($U_{gr}$) dependent upon the discharge current (I) for the battery voltage falling with the discharge, and a device for comparing this voltage ($U_{gr}$) with the continuously measured battery voltage (U).

**Patentansprüche**

1. Verfahren zur Überwachung des Ladungszustandes einer Speicherbatterie mit folgenden Schritten:

a) Speichern von den Ladungszustand darstellenden Bezugsdaten,

b) Messen der Batteriespannung ($U_{BAT}$), der Batterietemperatur (θ), und des die Batterie durchfließenden Stromes ($I_{BAT}$) zum Bereitstellen einer Anzeige des Ladungszustandes,

c) Integrieren bei eingeschaltetem Lademittel und/oder eingeschalteten bedeutenden Verbrauchern des Meßstromes ($I_{BAT}$) zur Bereitstellung einer Anzeige des Ladungsverlustes bzw. -gewinns (Q) nach Messung der Batteriespannung ($U_{BAT}$), und

d) Fortwährendes Schätzen der verfügbaren Restladung aus den gespeicherten Bezugsdaten und dem Ergebnis der Integrierung;

dadurch gekennzeichnet, daß die Schätzung der verfügbaren Restladung die folgenden weiteren Schritte umfaßt:

e) Messen der Spannung ($U_{BAT}$) und ihres zeitlichen Verlaufs in einem im wesentlichen offenen Schaltkreis,

f) Zuordnung, wenn dieser im wesentlichen offene Zustand für eine längere Zeitdauer andauert, des gemessenen Verlaufs der Restspannung zu vorher gespeicherten entsprechenden, für Batterien mit einem bekannten Ladungszustand gemessenen Verläufen,

g) Voraussage aus diesem Verlauf der hier definierten Relaxationsspannung ($U_{R1}$) der Batterie zur Bereitstellung der Anzeige des Ladungszustandes durch Vergleich der Relaxationsspannung mit den gespeicherten Bezugsdaten und Korrektur der vorausgesagten Relaxationsspannung durch jede Direktmessung der Relaxationsspannung ($U_{R1}$).

2. Verfahren nach Anspruch 1, dadurch gekennzeichnet, daß eine stromabhängige kritische Spannung von der Spannung der vollgeladenen Batterie abgeleitet wird und die gemessene Größe des Entladungsstromes und der kritischen Spannung mit der fortlaufend gemessenen Batteriespannung verglichen wird, um eine Warnanzeige bereitzustellen.

3. Verfahren nach Anspruch 1 oder 2, dadurch gekennzeichnet, daß der berechnete Ladungszustand der Batterie dazu benutzt wird, den Wiederaufladungszyklus und die Ladungsgeschwindigkeit bei nächstem Anschalten des Motors zu bestimmen.

4. Vorrichtung zur Durchführung des Verfahrens nach einem beliebigen vorhergehenden Anspruch, mit Meßmitteln (1, 2) zum fortlaufenden Messen des Batteriestromes ($I_{BAT}$) und der Batteriespannung ($U_{BAT}$); einem mit dem Strommeßmittel (2) verbundenen Integrator (9) zum Bestimmen der aus der Batterie entzogenen und ihr zugeführten Ladung (Q), Mittel (15) zum Berechnen einer Batterienennkapazität ($K_B$) aus der Meßspannung und der aus der Batterie entzogenen und ihr zugeführten Ladung (Q), Mittel (10) zum Vergleichen der entzogenen und zugeführten Ladung (Q), die fortlaufend vom Integrator (9) bestimmt wird, wenn der Batteriestrom wieder fließt, mit der berechneten Batterienennkapazität ($K_B$) und da mit zur fortlaufenden Bestimmung des Ladungszustandes (LZ), und einer Vorrichtung (3) zum fortlaufenden Messen der Batterietemperatur (θ) zum Bilden eines Korrekturwertes (ΔKθ) für die Batterienennkapazität aus dem Vergleich der Meßtemperatur (ø) mit einer vorbestimmten Nenntemperatur ($θ_N$), dadurch gekennzeichnet, daß eine Vorrichtung (14) an das Spannungsmeßmittel (1) angeschlossen ist und durch das Strommeßmittel (2) zum Messen der Restspannung und der Relaxationsspannung ($U_{R1}$) in einem im wesentlichen offenen Schaltkreis steuerbar ist, und daß sie Mittel zur Zuordnung, wenn dieser im wesentlichen offene Zustand für eine längere Zeitdauer andauert, des temperaturkompensierten gemessenen Verlaufs der Restspannung zu den vorher gespeicherten entsprechenden, für Batterien mit einem bekannten Ladungszustand gemessenen Verläufen und zur Voraussage aus diesem Verlauf der Relaxationsspannung umfaßt, und Mittel zum Korrigieren der vorausgesagten Relaxationsspannung mit jeder Direktmessung der Relaxationsspannung ($U_{R1}$).

5. Vorrichtung nach Anspruch 4, gekennzeichnet durch einen mit dem Mittel (10) zum Vergleichen des Ladungsentzugs (Q) mit der Batterienennkapazität ($K_B$) verbundenen und zur Bereitstellung eines Warn- oder Steuersignals bei Unterschreiten des Batterieladungszustandes eines vorbestimmten Pegels angeordneten Alarm (11).

6. Vorrichtung nach Anspruch 4 oder 5, weiterhin gekennzeichnet durch Mittel (12) zum fortlaufenden Bestimmen eines Maximalwertes ($U_{gr}$) in Abhängigkeit des Entladungsstromes (I) für die mit der Entladung fallende Batteriespannung, und eine Vorrichtung zum Vergleichen dieser Spannung ($U_{gr}$) mit der fortlaufend gemessenen Batteriespannung (U).

**Revendications**

1. Procédé pour surveiller l'état de charge d'un accumulateur qui comprend les étapes selon lesquelles :

a) on enregistre des données de référence représentatives de l'état de charge,

b) on mesure la tension ($U_{BAT}$) de la batterie, la température (θ) de la batterie et le courant ($I_{BAT}$) qui passe à travers la batterie pour fournir une indication de l'état de charge,

c) lorsqu'un moyen de charge et/ou des charges extérieures significatives sont mises en circuit, on intègre le courant mesuré ($I_{BAT}$) pour fournir une indication de la perte ou du gain de charge (Q) suivant la mesure de la tension ($U_{BAT}$) de la batterie, et :

d) on estime en continu la charge restante disponible à partir des données de référence enregistrées et du résultat de l'intégration ;

caractérisé par le fait que l'estimation de la charge restante disponible comprend les étapes supplémentaires selon lesquelles :

e) on mesure la tension ($U_{BAT}$) et sa variation en fonction du temps dans un circuit sensiblement ouvert,

f) si cet état sensiblement ouvert persiste pendant une durée prolongée, on corrèle la variation mesurée de la tension résiduelle avec des variations correspondantes préalablement enregistrées et mesurées sur des batteries dont l'état de charge est connu,

g) on prévoit à partir de cette variation la tension de relaxation ($U_{R1}$) de la batterie, telle qu'elle est définie ici, pour fournir l'indication de l'état de charge en comparant la tension de relaxation aux données de référence enregistrées et en corrigeant la tension de relaxation prévue par chaque mesure directe de la tension de relaxation ($U_{R1}$).

2. Procédé selon la revendication 1, dans lequel une tension critique dépendant du courant est dédite de la tension de la batterie complètement chargée et de l'intensité mesurée du courant de décharge, et la tension critique est comparée à la tension constamment mesurée de la batterie pour fournir une indication d'avertissement.

3. Procédé selon la revendication 1 ou 2, dans lequel l'état de charge calculé de la batterie est utilisé pour déterminer le cycle de recharge et le régime de charge lorsque le moteur est mis en route la fois suivante.

4. Appareil pour la mise en oeuvre du procédé selon l'une quelconque des revendications précédentes, comprenant des moyens de mesure (1, 2) pour la mesure continue du courant de batterie ($I_{BAT}$) et de la tension ($U_{BAT}$) de la batterie ; un intégrateur (9) relié aux moyens de mesure du courant (2) pour déterminer la charge (Q) prélevée dans la batterie et fournie à celle-ci ; des moyens (15) pour calculer une capacité fictive ($K_B$) de la batterie à partir de la tension mesurée et de la charge (Q) prélevée dans la batterie et fournie à celle-ci ; des moyens (10) pour comparer les charges (Q) prélevée et fournie, que l'intégrateur (9) détermine en continu lorsque le courant de la batterie passe à nouveau, avec la capacité fictive calculée ($K_B$) de la batterie, et donc pour déterminer en continu l'état de charge (LZ) ; et un dispositif (3) pour mesurer en continu la température (θ) de la batterie pour former une valeur de correction (ΔKθ) pour la capacité fictive de la batterie à partir de la comparaison de la température mesurée ($\theta$) avec une température nominale prédéterminée ($\theta_N$), caractérisé par le fait qu'un dispositif (14) est relié aux moyens de mesure de la tension (1), et qu'il peut être commandé par les moyens de mesure du courant (2) pour mesurer la tension résiduelle et la tension de relaxation ($U_{R1}$) dans un circuit sensiblement ouvert, et par le fait qu'il comprend des moyens pour corréler, si cet état sensiblement ouvert persiste pendant une durée prolongée, la variation mesurée, et compensée quant à la température, de la tension résiduelle avec les variations correspondantes préalablement enregistrées mesurées pour des batteries dont l'état de charge est connu, et pour prévoir la tension de relaxation à partir de cette variation, et des moyens pour corriger la tension de relaxation prévue par chaque mesure directe de la tension de relaxation ($U_{R1}$).

5. Appareil selon la revendication 4, comprenant une alarme (11) qui est reliée aux moyens (10) pour comparer le prélèvement de charge (Q) à la capacité fictive ($K_B$) de la batterie, et qui est susceptible de fournir un signal d'avertissement ou de commande lorsque l'état de la charge de la batterie tombe au-dessous d'un niveau prédéterminé.

6. Appareil selon les revendications 4 ou 5, comprenant en outre des moyens (12) pour déteminer en continu une valeur maximale ($U_{gr}$) dépendant du courant de décharge (I) pour la tension de la batterie qui baisse avec la décharge, et un dispositif pour comparer cette tension ($U_{gr}$) à la tension de la batterie (U) mesurée en continu.

Fig.1.

EP 0 225 364 B1

$$\Delta U_{Rmax} = U_{R0} - U_{Rmin}$$

Fig. 2.